# EUROPEAN PATENT APPLICATION

(11) **EP 4 636 815 A2**
(43) Date of publication of application: **22.10.2025**
(21) Application number: 25166401.7
(22) Date of filing: 26.03.2025
(51) Int. Cl.: H01L 21/67

(54) **DISPLAY METHOD, METHOD OF MANUFACTURING SEMICONDUCTOR DEVICE, PROGRAM, PROCESSING APPARATUS, AND MANAGEMENT APPARATUS**

(30) Priority: 28.03.2024 JP 2024054319
(71) Applicant: Kokusai Electric Corporation, Tokyo 101-0045 (JP)
(72) Inventor: OKAZAKI, Tadashi, Toyama-shi, Toyama 9392393 (JP); YONEDA, Akihiko, Toyama-shi, Toyama 9392393 (JP)
(74) Representative: Bardehle Pagenberg Partnerschaft mbB Patentanwälte Rechtsanwälte

(57) **Abstract**

There is provided a technique that includes displaying time information indicating a usage time of a component including an operable component among a process component used in a processor that processes a substrate, a flow rate control component used in an atmosphere controller that includes a gas supply system or a gas exhaust system and is configured to be capable of controlling an internal atmosphere of the processor, and a transfer control component used in a transferer that transfers the substrate, and quality information indicating that the component is determined to be in a predetermined level of a quality state, in association with the time information for each determination timing of the quality state.

## Description

### CROSS-REFERENCE TO RELATED APPLICATION

This application is based upon and claims the benefit of priority from Japanese Patent Application No. 2024-054319, filed on March 28, 2024, the entire contents of which are incorporated herein by reference.

### TECHNICAL FIELD

The present disclosure relates to a display method, a method of manufacturing semiconductor device, a program, a processing apparatus, and a management apparatus.

### BACKGROUND

In the related art, a replacement time of a component may be displayed.

However, simply displaying the replacement time of the component does not allow a user to know a condition of the component, and may not be able to grasp an appropriate replacement time of the component.

### SUMMARY

Some embodiments of the present disclosure provide a technique capable of notifying a user of a condition of a component and a replacement time of the component in a substrate processing apparatus.

According to embodiments of the present disclosure, there is provided a technique that includes displaying time information indicating a usage time of a component including an operable component among a process component used in a processor that processes a substrate, a flow rate control component used in an atmosphere controller that includes a gas supply system or a gas exhaust system and is configured to be capable of controlling an internal atmosphere of the processor, and a transfer control component used in a transferer that transfers the substrate, and quality information indicating that the component is determined to be in a predetermined level of a quality state, in association with the time information for each determination timing of the quality state.

### BRIEF DESCRIPTION OF DRAWINGS

The accompanying drawings, which are incorporated in and constitute a part of the specification, illustrate embodiments of the present disclosure.
FIG. 1 is a schematic diagram showing an example of a processing system according to a first embodiment.
FIG. 2 is a schematic perspective view showing a substrate processing apparatus according to the first embodiment.
FIG. 3 is a schematic side cross-sectional view showing the substrate processing apparatus according to the first embodiment.
FIG. 4 is a schematic side cross-sectional view showing a process furnace according to the first embodiment.
FIG. 5 is a block diagram showing an example of a functional configuration of a controller provided in a management apparatus and a controller provided in the substrate processing apparatus according to the first embodiment.
FIG. 6 is a diagram showing an example of a schematic of components data in the first embodiment.
FIG. 7 is a schematic diagram showing an example of a functional configuration of the controller according to the first embodiment.
FIG. 8 is an explanatory diagram of a case in which a service life of a constituting component according to the first embodiment is shortened.
FIG. 9 is a schematic diagram showing an example of a display screen of a display according to the first embodiment.
FIG. 10 is a schematic diagram showing a modification of the display screen of the display according to the first embodiment.
FIG. 11 is a schematic diagram showing a modification of the display screen of the display according to the first embodiment.
FIG. 12 is a schematic diagram showing a modification of the display screen of the display according to the first embodiment.
FIG. 13 is a flowchart showing an example of a flow of a storage process according to the first embodiment.
FIG. 14 is a flowchart showing an example of a flow of a display process according to the first embodiment.
FIG. 15 is a flowchart showing an example of a flow of a storage process according to a second embodiment.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

Hereinafter, some embodiments of the present disclosure are described with reference to the drawings. The drawings are merely schematic diagrams, and a size of each part shown in the drawing and a size ratio between parts may not reflect an actual device. Further, symbols that appear in common in the drawings indicate common configurations even if they are not mentioned in the description of the drawings. Furthermore, the present disclosure is not limited to the following embodiments, and may be implemented with appropriate modifications within the scope of the present disclosure.

### [First Embodiment]

### (Processing System)

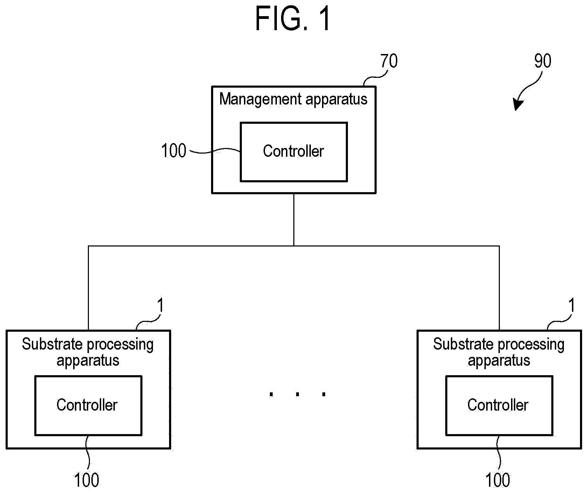

FIG. 1 is a schematic diagram showing an example of a processing system 90 according to a first embodiment.

As shown in FIG. 1, the processing system 90 of the embodiment includes a management apparatus 70 and a plurality of substrate processing apparatuses 1. Further, the management apparatus 70 and the plurality of substrate processing apparatuses 1 include respective controllers 100 as control parts. The controllers 100 control the respective management apparatus 70 and substrate processing apparatuses 1.

The management apparatus 70 is connected to the plurality of substrate processing apparatuses 1, such as a deposition apparatus for CVD (Chemical Vapor Deposition) and a diffusion apparatus, via a communication line. The management apparatus 70 performs a function of collecting apparatus data transmitted from the substrate processing apparatuses 1. Also, it is sufficient as long as at least one substrate processing apparatus 1 is connected.

### (Substrate Processing Apparatus)

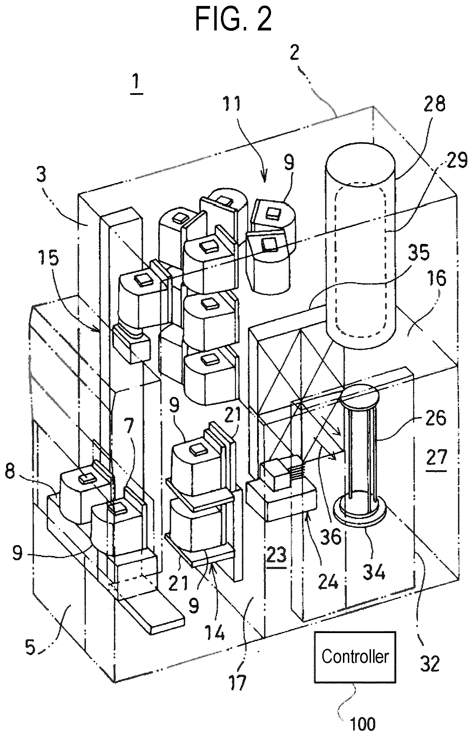

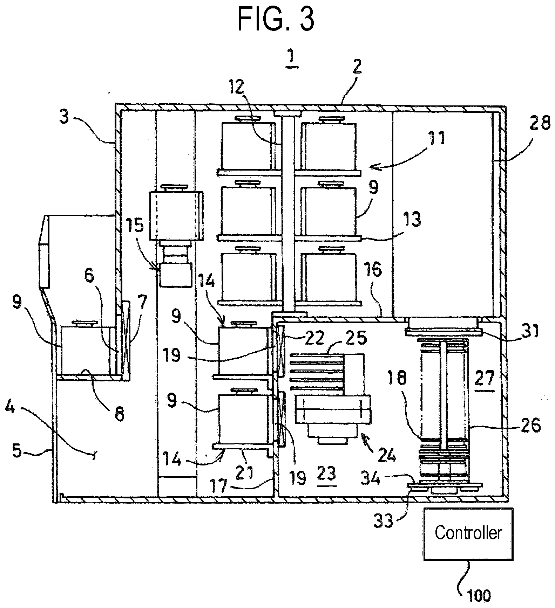

Next, a configuration of a substrate processing apparatus 1 as a processing apparatus of the embodiment is described with reference to FIGS. 2 to 4. As shown in FIGS. 2 and 3, the substrate processing apparatus 1 is provided with the controller 100. The controller 100 is electrically connected to each constituting component in the substrate processing apparatus 1. Each constituting component as at least an operable component is operated according to an instruction of the controller 100.

The substrate processing apparatus 1 includes a housing 2, and a front maintenance port 4 as an opening provided for maintenance is provided at a lower portion of a front wall 3 of the housing 2 and is opened/closed by a front maintenance door 5.

A pod loading/unloading port 6 is provided at the front wall 3 of the housing 2 so as to communicate between an inside and an outside of the housing 2. The pod loading/unloading port 6 is opened/closed by a front shutter (loading/unloading port opening/closing mechanism) 7. A load port (substrate transfer container delivery table) 8 is installed in front of the pod loading/unloading port 6. The load port 8 is configured to align a pod 9 mounted thereon.

The pod 9 is a sealed substrate transfer container, and is loaded onto the load port 8 and is unloaded from the load port 8 by an in-process transfer apparatus (not shown).

A rotary pod shelf (substrate transfer container storage shelf) 11 is installed at an upper portion of the housing 2 at approximately a central portion in a front-to-rear direction. The rotary pod shelf 11 is configured to store a plurality of pods 9.

The rotary pod shelf 11 includes a post 12 that is vertically erected and intermittently rotated, and a plurality of shelf boards (substrate transfer container mounting shelves) 13 that are radially supported at respective positions of upper, middle, and lower stages of the post 12. The shelf boards 13 are configured to store the plurality of pods 9 mounted on them.

Pod openers (substrate transfer container lid opening/closing mechanism) 14 are provided below the rotary pod shelf 11, and the pod openers 14 are configured to mount the pods 9 thereon and are configured to be capable of opening/closing lids of the pods 9.

A pod transfer mechanism (container transfer mechanism) 15 is installed between the load port 8, the rotary pod shelf 11, and the pod openers 14. The pod transfer mechanism 15 is configured to be capable of moving up and down and moving back and forth horizontally while holding the pods 9, and to transfer the pods 9 among the load port 8, the rotary pod shelf 11, and the pod openers 14.

A sub-housing 16 is provided at a lower portion of the housing 2 from approximately the central portion in the front-to-rear direction to a rear end. A pair of substrate loading/unloading ports 19 for loading/unloading substrates 18 into/from the sub-housing 16 are provided vertically in two upper and lower stages on a front wall 17 of the sub-housing 16. The pod openers 14 are provided for the substrate loading/unloading ports 19 on the upper and lower stages, respectively.

Each pod opener 14 includes a mounting table 21 on which the pod 9 is mounted, and an opening/closing mechanism 22 for opening/closing the lid of the pod 9. The pod opener 14 is configured to open/close a substrate entrance/exit of the pod 9 by opening/closing the lid of the pod 9 mounted on the mounting table 21 by using the opening/closing mechanism 22.

The sub-housing 16 forms a transfer chamber 23 that is kept airtight from a space (pod transfer space) in which the pod transfer mechanism 15 and the rotary pod shelf 11 are disposed. A substrate transfer mechanism 24 as a transfer robot is installed in a front area of the transfer chamber 23. The substrate transfer mechanism 24 includes a plurality of shafts (not shown) as a driver, and a certain number (five in the figure) of substrate mounting plates 25 for mounting the substrates 18. The substrate mounting plates 25 is configured to be capable of moving linearly in a horizontal direction, rotating in the horizontal direction, or moving up and down. The substrate transfer mechanism 24 is configured to load/unload the substrates 18 into/from a boat (substrate holder) 26.

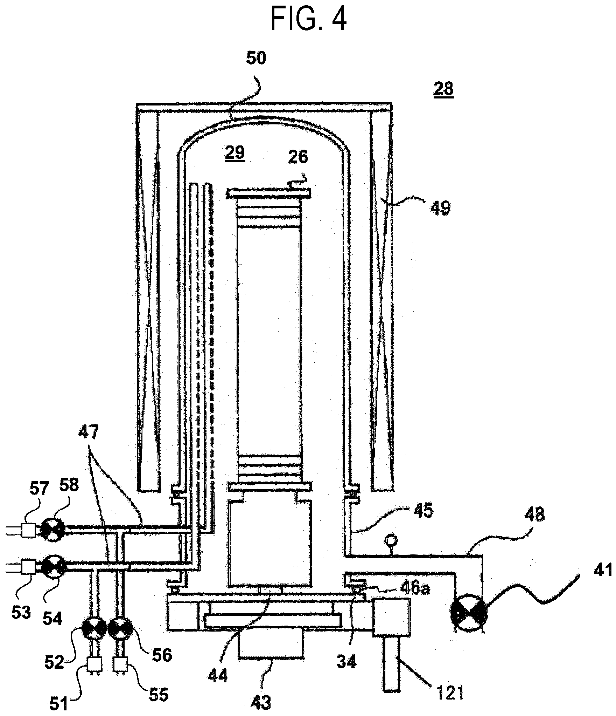

A standby portion 27 is configured in a rear area of the transfer chamber 23 to accommodate the boat 26 and keep it on standby, and a vertical process furnace 28 is provided above the standby portion 27. The process furnace 28 forms a process chamber 29 therein, and a lower end of the process chamber 29 forms a furnace opening that is opened/closed by a furnace opening shutter (furnace opening/closing mechanism) 31. The process furnace 28 is described in detail in FIG. 4 later.

A boat elevator (substrate holder elevating mechanism) 32 for raising and lowering the boat 26 is installed between a right end of the housing 2 and a right end of the standby portion 27 of the sub-housing 16. A seal cap 34 as a lid is attached horizontally to an arm 33 connected to an elevating stand of the boat elevator 32. The seal cap 34 supports the boat 26 vertically and is configured to be capable of air-tightly closing the furnace opening in a state where the boat 26 is loaded into the process chamber 29.

The boat 26 is configured to hold a plurality of substrates 18 (e.g., about 50 to 125 substrates) in multiple stages in a horizontal position with the substrates 18 aligned at their centers.

A clean unit 35 is disposed at a position opposite the boat elevator 32. The clean unit 35 is configured with a supply fan and a filter to supply clean air 36, which is a purified atmosphere or an inert gas. A notch aligner (not shown) as a substrate aligner for aligning positions of the substrates 18 in a circumferential direction is installed between the substrate transfer mechanism 24 and the clean unit 35.

The clean air 36 blown out from the clean unit 35 is circulated through the notch alignment device (not shown), the substrate transfer mechanism 24, and the boat 26, and then sucked in by a duct (not shown) and exhausted to the outside of the housing 2, or blown into the transfer chamber 23 by the clean unit 35.

### (Process Furnace)

As shown in FIG. 4, the process furnace 28 includes a reaction tube 50. The reaction tube 50 is made of, for example, heat resistant nonmetallic material such as quartz (SiO₂) or silicon carbide (SiC), and is formed in a cylindrical shape with its upper end closed and its lower end opened.

The process chamber 29 capable of processing the substrates 18 is formed inside the reaction tube 50, for example. In other words, the substrate processing apparatus 1 includes the process chamber 29. The boat 26 as a substrate holder is inserted from below into the process chamber 29, and the substrates 18 held in a horizontal posture by the boat 26 are accommodated in the process chamber 29 in a state where the substrates 18 are aligned in multiple stages in a vertical direction. The boat 26 accommodated in the process chamber 29 is configured to be rotatable with the plurality of substrates 18 mounted thereon while maintaining an airtightness of the process chamber 29 by rotating a rotary shaft 44 by a rotator 43.

A manifold 45 is disposed to be concentric with the reaction tube 50 below the reaction tube 50. The manifold 45 is made of, for example, a metal material such as stainless steel, and is formed in a cylindrical shape with its upper and lower ends opened. The reaction tube 50 is supported vertically from its lower end by the manifold 45. In other words, the reaction tube 50 forming the process chamber 29 is vertically erected via the manifold 45 to form the process furnace 28. The lower end of the manifold 45 is configured to be air-tightly sealed by the seal cap 34 as a sealing portion when the boat elevator 32 rises. A seal 46a such as an O-ring is provided between the lower end of the manifold 45 and the seal cap 34 to air-tightly seal the process chamber 29.

In addition, a gas introduction pipe 47 for introducing a precursor gas, a purge gas, etc. into the process chamber 29 and an exhaust pipe 48 for exhausting a gas from the process chamber 29 are connected to the manifold 45. A pressure of the process chamber 29 is controlled while regulating an APC valve 41 based on a detection result of a pressure sensor (not shown). In addition, the gas introduction pipe 47 is provided with mass flow controllers (MFCs) and valves (opening/closing valves) as flow rate control components, sequentially from an upstream. The MFCs provided at the gas introduction pipe 47 in the embodiment include MFCs 51, 53, 55, and 57, and the valves include valves 52, 54, 56, and 58. The gas introduction pipe 47 in the embodiment is composed of two gas introduction pipes, each of which is formed by joining two pipes among four pipes on an upstream. One gas introduction pipe is configured to join two of the four pipes on the upstream, and the other gas introduction pipe is configured to join the remaining two pipes. One gas introduction pipe is configured, for example, to join a pipe installed with the MFC 51 and the valve 52 sequentially from the upstream and a pipe installed with the MFC 53 and the valve 54 sequentially from the upstream. In addition, the other gas introduction pipe is configured, for example, to join a pipe installed with the MFC 55 and the valve 56 sequentially from the upstream and a pipe installed with the MFC 57 and the valve 58 sequentially from the upstream.

A heater unit 49 (heating mechanism) is disposed to be concentric with the reaction tube 50 on an outer periphery of the reaction tube 50. The heater unit 49 is configured to heat the process chamber 29 so that a uniform or predetermined temperature distribution is obtained throughout the process chamber 29.

Next, an operation of the substrate processing apparatus 1 is described.

### (Operation of Substrate Processing Apparatus)

When the pod 9 is supplied to the load port 8, the pod loading/unloading port 6 is opened by the front shutter 7. The pod 9 on the load port 8 is loaded into the housing 2 through the pod loading/unloading port 6 by the pod transfer mechanism 15 and is placed on a designated shelf board 13 of the rotary pod shelf 11. The pod 9 is temporarily stored on the rotary pod shelf 11 and then is transferred from the shelf board 13 to one of the pod openers 14 by the pod transfer mechanism 15 and transferred to the mounting table 21, or is directly transferred from the load port 8 to the mounting table 21.

At this time, the substrate loading/unloading port 19 is closed by the opening/closing mechanism 22, and the clean air 36 is circulated through the transfer chamber 23 to fill it. For example, the transfer chamber 23 is filled with a nitrogen gas as the clean air 36, so that an oxygen concentration is set to 20 ppm or less, which is much lower than an oxygen concentration inside the housing 2 (of the atmospheric atmosphere).

An opening side end face of the pod 9 mounted on the mounting table 21 is pressed against an opening edge of the substrate loading/unloading port 19 at the front wall 17 of the sub-housing 16, and the lid is removed by the opening/closing mechanism 22 to open the substrate entrance/exit.

When the pod 9 is opened by the pod opener 14, the substrate 18 is taken out from the pod 9 by the substrate transfer mechanism 24 and is transferred to the notch aligner (not shown). After the notch aligner aligns the substrate 18, the substrate transfer mechanism 24 loads the substrate 18 into the standby portion 27 at the rear area of the transfer chamber 23 and charges it into the boat 26.

After delivering the substrate 18 to the boat 26, the substrate transfer mechanism 24 returns to the pod 9 and charges the next substrate 18 into the boat 26.

During the charging work of the substrate 18 into the boat 26 by the substrate transfer mechanism 24 in one (upper or lower) pod opener 14, another pod 9 is transferred by the pod transfer mechanism 15 from the rotary pod shelf 11 to another (lower or upper) pod opener 14, so that the opening work of the pod 9 by the another pod opener 14 is simultaneously performed.

When a pre-specified number of substrates 18 are charged into the boat 26, the furnace opening of the process furnace 28, which was closed by the furnace opening shutter 31, is opened by the furnace opening shutter 31. Subsequently, the boat 26 is raised by the boat elevator 32 and is loaded into the process chamber 29.

After the loading, the furnace opening is air-tightly closed by the seal cap 34. In the embodiment, at this timing (after the loading), a purge step (pre-purge step) is performed in which the process chamber 29 is substituted with an inert gas.

The process chamber 29 is vacuum-exhausted by the APC valve 41 so as to reach a desired pressure (vacuum degree). In addition, the process chamber 29 is heated to a predetermined temperature by the heater unit 49 so as to achieve a desired temperature distribution.

In addition, a process gas controlled to be at a predetermined flow rate is supplied by a gas supplier, and while the process gas circulates through the process chamber 29, it comes into contact with a surface of the substrate 18, and a predetermined process is performed on the surface of the substrate 18. Further, the process gas after reaction is exhausted from the process chamber 29 by a gas exhauster.

When a preset process time is elapsed, an inert gas is supplied from an inert gas supply source (not shown) by the gas supplier, and the process chamber 29 is substituted with the inert gas, and the pressure of the process chamber 29 is returned to normal pressure (after-purge step). Then, the boat 26 is lowered via the seal cap 34 by the boat elevator 32.

To unload the processed substrate 18, the substrate 18 and the pod 9 are discharged to the outside of the housing 2 in the reverse order to that described above. An unprocessed substrate 18 is further charged into the boat 26, and the batch processing of the substrate 18 is repeated.

### (Configuration of Controller)

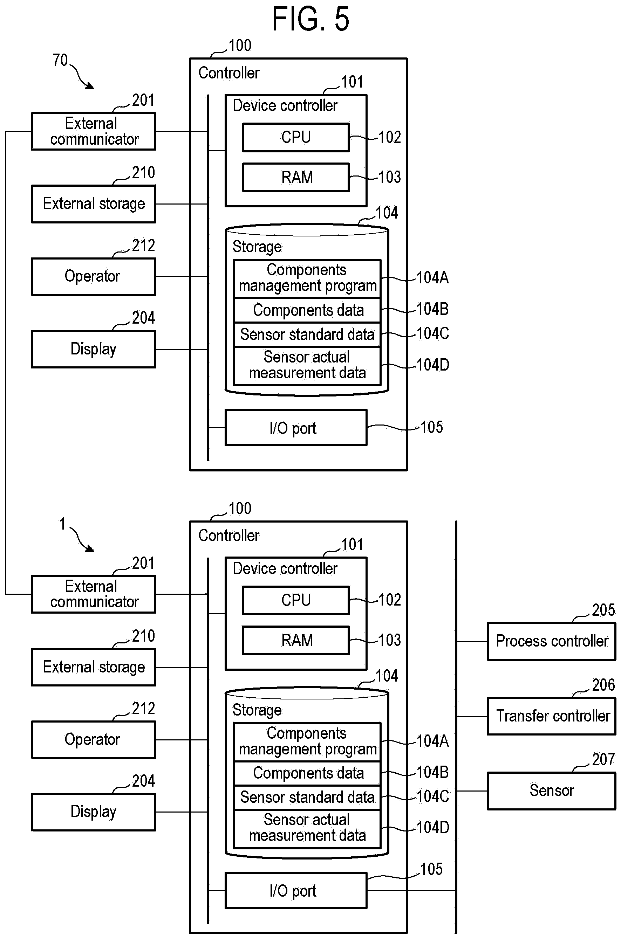

Next, the controller 100 that controls the process furnace 28 as a processor, the transfer mechanism as a transferer, the gas supplier as a gas supply system included in an atmosphere controller, the gas exhauster as a gas exhaust system included in the atmosphere controller, and the heating mechanism as the processor is described with reference to FIGS. 5 to 7. Herein, the transfer mechanism includes at least the pod transfer mechanism 15, which is a mechanism for transferring the substrate, the substrate transfer mechanism 24, the boat elevator 32, the rotator 43, the rotary shaft 44 as a transfer control component, and the like. In addition, the gas supplier includes the gas introduction pipe 47 as a flow rate control component for supplying the process gas, etc. into the process furnace 28. In addition, the gas exhauster includes the exhaust pipe 48, the APC valve 41, a vacuum pump (not shown), and the like, which are flow rate control components for exhausting an interior of the process furnace 28. In addition, the heating mechanism includes the heater unit 49 which is a process component for heating the process furnace 28.

FIG. 5 is a block diagram showing an example of a functional configuration of the controller 100 included in the substrate processing apparatus 1 and the management apparatus 70 according to the first embodiment. The controller 100 of the substrate processing apparatus 1 and the controller 100 of the management apparatus 70 according to the embodiment include the same configuration, so the controller 100 of the substrate processing apparatus 1 is described as a representative.

As shown in FIG. 5, the substrate processing apparatus 1 includes the controller 100 as a main controller, an external communicator 201, an external storage 210, an operator 212, a display 204, a process controller 205, a transfer controller 206, and a sensor 207 as a detector.

The controller 100 includes a device controller 101, a storage 104, and an I/O (also called an I/O port) 105.

The device controller 101 includes a CPU (Central Processing Unit) 102 and a RAM (Random Access Memory) 103.

The CPU 102 is a central processing unit that executes various programs and controls each part. The RAM 103, as a working area, temporarily stores programs or data. The storage 104 stores various programs and data. That is, the CPU 102 of the controller 100 according to the embodiment functions as the device controller 101 by writing the program stored in the storage 104 into the RAM 103 and executing it.

The storage 104 may be, for example, a HDD (Hard Disk Drive), a SSD (Solid State Drive), a flash memory, or the like. The storage 104 stores various recipe files, such as recipes in which process conditions and process procedures are defined, control program files for executing these recipe files, parameter data (setting value files) for setting process conditions and process procedures, error processing program files and parameter data for error processing, various screen files including an input screen for inputting process parameters, various icon files, etc. (none of which are shown). In the embodiment, the storage 104 stores a components management program 104A for managing constituting components of the substrate processing apparatus 1, components data 104B, sensor standard data 104C, and sensor actual measurement data 104D.

The components management program 104A is a program for executing processes including a storage process and a display process, which are described later. The program may be pre-installed in the substrate processing apparatus 1, for example. The program may be realized by recording it on a non-volatile recording medium or distributing it via a network and installing it appropriately in the substrate processing apparatus 1. Examples of the non-volatile recording medium may include a CD-ROM, a magneto-optical disc, a HDD, a DVD-ROM, a flash memory, a memory card, a USBs, etc.

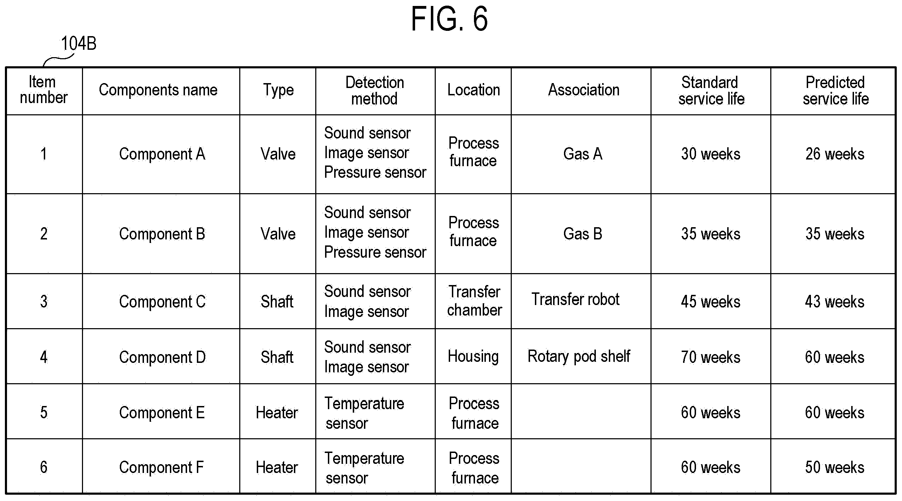

FIG. 6 is a diagram showing an example of a schematic of components data 104B of the first embodiment.

As shown in FIG. 6, the components data 104B is data that consolidates information on constituting components. The components data 104B is configured to include items such as item number, component name, type, detection method, location, association, standard service life, and predicted service life. The components data 104B also includes a warning level (not shown) as a predetermined level indicating a quality state of a constituting component determined by a data determiner 100B to be described later, and a timing (not shown) at which the determination is made (hereinafter also referred to as a warning timing).

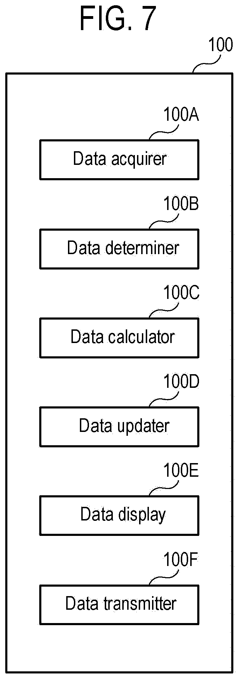

The item number column indicates an order in which the components management program to be described later reads data, and in principle, the items are displayed in a list on the display 204 to be described later in the order of the item number. The components name column indicates the name of a constituting component to be subject to maintenance management. The type column indicates the type of the constituting component. The detection method column indicates which sensor of the sensor 207 to be described later detects an abnormality. The location column indicates a location where each constituting component is located. The association column indicates a type of a gas used, a mechanism used, etc. The standard service life column indicates a standard service life of each constituting component, for example, the service life appropriately set by a component maker's recommended value or a specification value of the component, etc. The predicted service life column indicates a service life of each constituting component as an expected usage period calculated by a data calculator 100C *(see* FIG. 7) to be described later. FIG. 6 is one example, and items may be added or deleted as desired.

The sensor standard data 104C in FIG. 5 stores standard data of each constituting component as comparison information. The standard data is data to be compared with detection data acquired by the sensor 207 when each constituting component is in operation. The standard data and the detection data include sound data, image data, temperature data, odor data, pressure data, etc. The standard data and the detection data are represented by time series data such as waveforms, physical quantities such as average values and extreme values, image information such as pixel data and color depth, etc. The standard data stores, for example, a standard service life, and detection data when each constituting component is operated according to the component maker's recommended value or the specification value of the component. The standard data may also be an average value of the detection data of each constituting component while the substrate processing apparatus 1 is operating normally. The sensor actual measurement data 104D stores detection data of each constituting component as status information actually detected by the sensor 207 to be described later (hereinafter, also referred to as actual measurement data).

The controller 100 is connected to the operator 212, and is connected to the process controller 205, the transfer controller 206, and the sensor 207 via the I/O 105. The controller 100 is electrically connected to each of the process controller 205, the transfer controller 206, and the sensor 207 via the I/O 105, and is therefore configured to be capable of transmitting/receiving data and downloading/uploading files.

The controller 100 is connected to the management apparatus 70, an external host computer (not shown), and the like via the external communicator 201. The controller 100 is connected to a network, such as the Internet, a LAN (Local Area Network), or a WAN (Wide Area Network), by using the external communicator 201, and is capable of communicating with external devices via the network. Therefore, even if the substrate processing apparatus 1 is installed in a clean room, the management apparatus 70, the host computer, and the like may be placed in an office outside the clean room. In addition, the controller 100 is connected to an external storage 210 as an attachment part into/from which a USB (Universal Serial Bus) memory, which is an example of a recording medium, is inserted/removed.

The operator 212 is a so-called touch panel that either is integrated with the display 204 or is connected to the display 204 via a video cable or the like. The operator 212 displays information generated within the substrate processing apparatus 1 on the display 204 via an operation screen. The operator 212 also outputs the information displayed on the display 204 to a device such as the USB memory inserted into the external storage 210. The operator 212 receives input data (input instructions) from the operation screen displayed on the display 204 and transmits the input data to the controller 100.

The display 204 is configured to display information on the constituting components of the substrate processing apparatus 1. The display 204 is also configured to display various operation screens for operating the substrate processing apparatus 1. The operation screens include screens for checking states of a substrate process system controlled by the process controller 205 and a substrate transfer system controlled by the transfer controller 206. The display 204 may also be provided with various operation buttons as an input part for inputting operation instructions to the substrate process system and the substrate transfer system. Herein, the operator 212 and the display 204 are provided separately from the controller 100, but they may be configured to be included integrally in the controller 100.

The process controller 205 includes a temperature controller, a gas flow rate controller as an atmosphere controller, a pressure controller, and a sequencer, although not shown here. These temperature controller, gas flow rate controller, pressure controller, and sequencer each constitute a sub-controller and are electrically connected to the process controller 205, making it possible to transmit and receive data and download and upload files. The process controller 205 and each sub-controller (i.e., the temperature controller, the gas flow rate controller, the pressure controller, and the sequencer) may be configured separately or integrally.

The temperature controller is connected to a heating mechanism mainly including a temperature sensor, the heater unit 49, etc. Herein, a state of electric power supplied to the heater unit 49 is feedback-controlled based on temperature information detected by the temperature sensor serving as a temperature detector so that an internal temperature of the process chamber 29 becomes a predetermined temperature (film formation temperature).

The pressure controller is connected to a gas exhauster mainly including a pressure sensor, an APC valve 41 serving as a pressure valve, and a vacuum pump. Based on a pressure value detected by the pressure sensor, the pressure controller is configured to control an opening degree of the APC valve 41 and switching (on/off) of the vacuum pump so that an internal pressure of the process chamber 29 becomes a desired pressure at a desired timing.

The gas flow rate controller is configured to include MFCs (MFCs 51, 53, 55, 57, etc.) serving as flow rate control components. The sequencer is configured to control supply and stop of a gas from the gas introduction pipe 47 by opening/closing valves (valves 52, 54, 56, 58, etc.). In addition, the process controller 205 is configured to control the MFCs and the sequencer so that a flow rate of a gas supplied into the process chamber 29 becomes a desired flow rate at a desired timing.

The transfer controller 206 includes a mechanism controller, although not shown here. This mechanism controller is configured to control each of a drive system, a rotation system, and an elevation system of the substrate processing apparatus 1. The transfer controller 206 is configured to control the transfer operation of the transfer mechanism including, for example, the pod transfer mechanism 15, the substrate transfer mechanism 24, the boat elevator 32, the rotator 43, the rotary shaft 44, etc.

The sensor 207 includes various sensors, although not shown here, that detect a state of each component used in the substrate processing apparatus 1. The sensor 207 may be, for example, a sound sensor (e.g., a microphone) that detects an operating sound of each constituting component while the substrate processing apparatus 1 is operating, an image sensor (e.g., a camera) that detects a color, expansion, etc. of each constituting component, a temperature sensor that detects a temperature of each constituting component, an odor sensor that detects an odor of each constituting component, a pressure sensor that detects a pressure applied to each constituting component, etc.

Functions of a device controller 71, a CPU 72, a RAM 73, a storage 74, and an I/O 75 of the management apparatus 70 are the same as the functions of the device controller 101, the CPU 102, the RAM 103, the storage 104, and the I/O 105 of the above-described controller 100. In addition, functions of an external communicator 81, an external storage 80, an operator 82, and a display 84 electrically connected to the management apparatus 70 are the same as the functions of the above-described external communicator 201, external storage 210, operator 212, and display 204.

### (Functions of Controller)

FIG. 7 is a diagram showing an example of a functional configuration of the controller 100 according to the first embodiment. In the controller 100 of the embodiment, the CPU 102 executes the components management program 104A to function as a data acquirer 100A, a data determiner 100B, a data calculator 100C, a data updater 100D, a data display 100E, and a data transmitter 100F.

The data acquirer 100A performs a function of acquiring data related to constituting components. The data acquirer 100A acquires, for example, detection data of each constituting component detected by the sensor 207, and stores the detection data in the sensor actual measurement data 104D *(see* FIG. 5) of the storage 104. The data acquirer 100A also acquires a warning level determined by the data determiner 100B to be described later, and a warning timing as a determination timing.

The data determiner 100B performs a function of determining the quality state of the constituting component. Specifically, the data determiner 100B determines the warning level indicating the quality state of the constituting component by comparing the actual measurement data with the standard data. For example, the data determiner 100B determines a sound level (i.e., warning level) of a sound detected from the constituting component by comparing the sound data stored in the sensor actual measurement data 104D *(see* FIG. 5) acquired by the data acquirer 100A with the sound data stored in the sensor standard data 104C *(see* FIG. 5) of the storage 104. More specifically, the data determiner 100B compares a waveform of the sound detected from the constituting component with the standard data and determines the sound level based on a shift of a peak on a time axis, a shift of a peak size, etc. The determination based on the sound data is merely one example, and the data determiner 100B may determine the quality state of the constituting component based on other types of detection data. For example, the data determiner 100B determines the quality state of the constituting component based on the types of detection data detected by the sensor 207, such as an odor, discoloration, change in shape, and surface temperature of the constituting component.

The data determiner 100B may also determine the warning level indicating the quality state of the constituting component based on the number of times it is judged that the constituting component may be wearing out. Further, the data determiner 100B may decide the warning level indicating the quality state of the constituting component by comparing the actual measurement data with each other.

The data calculator 100C performs a function of calculating the predicted service life of each constituting component from the quality state of the constituting component. The data calculator 100C calculates the predicted service life of the constituting component by shortening the standard service life by a period corresponding to the sound level determined by the data determiner 100B, for example.

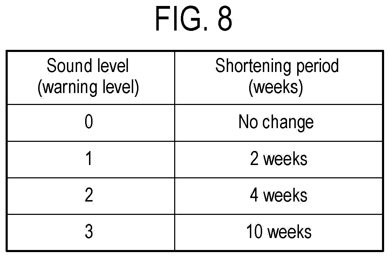

FIG. 8 is an explanatory diagram of a case in which the service life of the constituting component according to the first embodiment is shortened. As shown in FIG. 8, in the embodiment, the sound level (i.e., the warning level) is set from 0 to 3. As the sound level progresses from 0 to 3, it indicates that a larger difference is occurring between a sound waveform of the actual measurement data and a sound waveform of the standard data. Moreover, as the sound level progresses from 0 to 3, it indicates that the constituting component is more likely to be worn out, and a degree of recommendation for replacing the constituting component is higher. Then, as the sound level progresses from 0 to 3, the period for shortening the predicted service life of the constituting component is set to be longer. Herein, the data acquirer 100A acquires, for example, a timing at which the sound level is determined to be 1 or more and 3 or less.

For example, when the sound level is determined to be 0, a ratio of difference between peaks of the sound waveforms of the actual measurement data and the standard data is extremely low (for example, 0% or more and less than 10%), and the predicted service life of the constituting component is not shortened. When the sound level is determined to be 1, the ratio of difference between the peaks of the sound waveforms of the actual measurement data and the standard data is low but needs attention (for example, 10% or more and less than 30%), and the predicted service life of the constituting component is shortened by two weeks from the standard service life. When the sound level is determined to be 2, the ratio of difference between the peaks of the sound waveforms of the actual measurement data and the standard data is high (e.g., 30% or more and less than 50%), and the predicted service life of the constituting component is shortened by 4 weeks from the standard service life. When the sound level is determined to be 3, the ratio of difference between the peaks of the sound waveforms of the actual measurement data and the standard data is extremely high (e.g., 50% or more), and the predicted service life of the constituting component is shortened by 10 weeks from the standard service life. That is, when the warning level as a difference level is determined to be 1 or more as a predetermined value in the actual measurement data of the constituting component, the predicted service life of the constituting component is calculated by shortening the standard service life by a period corresponding to the warning level.

Also, it is possible to shorten the predicted service life of the constituting component by the period corresponding to the warning level each time these warning levels are determined. In addition, it is possible to set the predicted service life of the component to a predicted service life that is set according to the warning level. For example, in response to the warning level indicating the quality of the constituting component being determined to be 1, the predicted service life of the constituting component is set to 40 weeks. Further, in response to the warning level indicating the quality of the constituting component being determined to be 2, the predicted service life of the constituting component is set to 30 weeks. Furthermore, in response to the warning level indicating the quality of the constituting component being determined to be 3, the predicted service life of the constituting component is set to 20 weeks.

The data updater 100D in FIG. 7 performs a function of updating the components data of each constituting component. Specifically, the data updater 100D updates the predicted service life, the determined warning level, and the warning timing of the constituting component. For example, the data updater 100D updates the value of the predicted service life column of the components data 104B of the storage 104 *(see* FIG. 6) to the predicted service life calculated by the data calculator 100C. The data updater 100D also stores the warning level and warning timing acquired by the data acquirer 100A in the components data 104B.

The data display 100E performs a function of displaying the service life, the warning level, and the warning timing of each constituting component. For example, the data display 100E displays the warning level determined by the data determiner 100B and the warning timing acquired by the data acquirer 100A on the display 204 in association with the predicted service life calculated by the data calculator 100C. The data display 100E may also simultaneously display the predicted service life before being updated by the data updater 100D and the predicted service life after being updated by the data updater 100D.

The data display 100E also performs a function of changing and displaying a color of an image. For example, a color of an image indicating the warning timing is changed and displayed according to the warning level determined by the data determiner 100B.

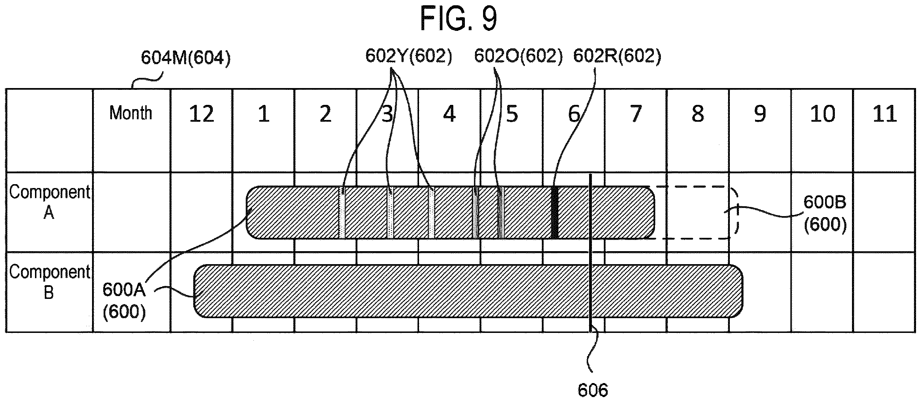

The data transmitter 100F performs a function of transmitting the components data of each constituting component to the management apparatus 70, an external host computer, etc. via the external communicator 201. The data transmitter 100F may transmit data for displaying a display screen *(see* FIGS. 9 to 12) to be described later on the management apparatus 70, the external host computer, etc. The management apparatus 70 causes the display 84 to display a display screen to be described later based on data received via the external communicator 81, for example.

### (Display Screen)

Next, a display screen of the display 204 according to the embodiment is described with reference to FIG. 9.

FIG. 9 is a schematic diagram showing an example of the display screen of the display 204 according to the first embodiment. As shown in FIG. 9, the display 204 displays a service life image 600 as a bar image and time information indicating the service life of each constituting component, a warning image 602 as quality information indicating the warning level and warning timing, a scale image 604 indicating a time scale as a time axis, and a date/time marker 606 indicating a current date/time. The service life image 600 of the embodiment includes a service life image 600A indicating the predicted service life after being updated by the data updater 100D, and a service life image 600B indicating the predicted service life before being updated by the data updater 100D. In addition, the warning image 602 of the embodiment includes a warning image 602Y corresponding to the warning level of 1, a warning image 602O corresponding to the warning level of 2, and a warning image 602R corresponding to the warning level of 3. The quality information is information indicating a quality level of the component. The time information is information indicating an expected life of the constituting component.

Herein, the service life image 600 is displayed to be superimposed on the scale image 604. For example, the service life image 600A is displayed as a blue rectangle with rounded corners, and is displayed to be superimposed on the service life image 600B. Further, the service life image 600B is displayed as a transparent rectangle with rounded corners drawn with a broken line. The service life image 600 corresponding to each constituting component is displayed in a row corresponding to the constituting component. The service life is indicated by a horizontal length of the service life image 600. Herein, the "left direction" and "right direction" in the explanation of the display screen correspond to the left direction and right direction of the display 204, respectively.

The warning image 602 is superimposed on the service life image 600 and is displayed at a position indicating each warning timing. For example, the warning image 602Y is displayed as a yellow rectangle at a position indicating a timing when the warning level is determined to be 1. The warning image 602O is displayed as an orange rectangle at a position indicating a timing when the warning level is determined to be 2. The warning image 602R is displayed as a red rectangle at a position indicating a timing when the warning level is determined to be 3.

The scale image 604 is an image showing a time scale when displaying the service life of the constituting component. For example, a scale image 604M is an image showing a time scale displayed in months, with a number indicating each month displayed in each square at the top. The name of each constituting component is displayed in a line at the left end. Further, the scale image 604 may be an image showing a time scale in units of minutes, hours, days, weeks, months, quarters, half years, years, etc.

The date/time marker 606 is displayed to be superimposed on the service life image 600 and the warning image 602 at a position corresponding to the current date/time. For example, the date/time marker 606 is displayed as a black vertical solid line across a plurality of rows.

In the embodiment, as an example, as shown in FIG. 9, the predicted service life, the warning level, the warning timing, etc. of components A and B are displayed. In FIG. 9, the scale image 604M is displayed, and the date/time marker 606 is displayed at a position indicating the last part of June. Displaying information on the components A and B is merely one example, and the constituting components to be displayed may be added or deleted as desired. In addition, the constituting components may be displayed by categorized group. For example, the constituting components may be displayed by categorized items (for example, type, detection method, location, association, etc.) included in the components data 104B. The display of rows corresponding to the components A and B is described below.

In the row corresponding to the component A, the service life image 600A is displayed from a position indicating the first part of January to a position indicating the last part of July. The service life image 600B is displayed from the position indicating the first part of January to a position indicating the first part of September, but is displayed to be superimposed on the service life image 600A. As a result, the service life image 600B from the position indicating the last part of July to the position indicating the first part of September is displayed without being hidden by the service life image 600A. The warning image 602Y is displayed at a position indicating the last part of February, the middle part of March, and the first part of April. The warning image 602O is displayed at a position indicating the last part of April and the middle part of May. The warning image 602R is displayed at a position indicating the first part of June.

In the row corresponding to the component B, the service life image 600A is displayed from a position indicating the middle part of December to a position indicating the first part of September. The warning image 602 is not displayed.

In this way, the warning images 602Y, 602O, and 602R are displayed to be superimposed on the service life image 600A of the row corresponding to the component A, thereby displaying the timing at which it is determined that the component A may be wearing out and the warning level at that timing. In addition, the service life image 600B of the row corresponding to the component A is displayed to display that the predicted service life of the component A is shortened by 6 weeks. That is, since there is a timing at which the warning level is determined to be 2 for the component A and a timing at which the warning level is determined to be 3 for the component A, it is displayed that the predicted service life of the component A is shortened by another 6 weeks (i.e., 10 weeks from the standard service life) from the time when it is shortened by 4 weeks from the standard service life. On the other hand, the warning image 602 is not displayed on the service life image 600A of the row corresponding to the component B. In addition, the service life image 600B of the row corresponding to the component B is not displayed. That is, it is displayed that there is no timing when the warning level is determined to be 1 or higher for the component B, and the predicted service life of the component B is not shortened.

The information indicated by the service life image 600 and the information indicated by the warning image 602 may also be displayed in text. For example, the information indicated by the service life image 600 is displayed as "January 1 to December 1", and the information indicated by the warning image 602 is displayed as "warning level 1: February 1, warning level 2: October 1 and October 5, warning level 3: October 10". If a constituting component is being used beyond its predicted service life, a message "The predicted service life is exceeded. It is strongly recommended that the component be replaced" is displayed. Further, the number of times that it is determined that each constituting component may be wearing out may be displayed by a radar chart. For example, the number of alarms up to the present time for the components A to F is displayed on the radar chart.

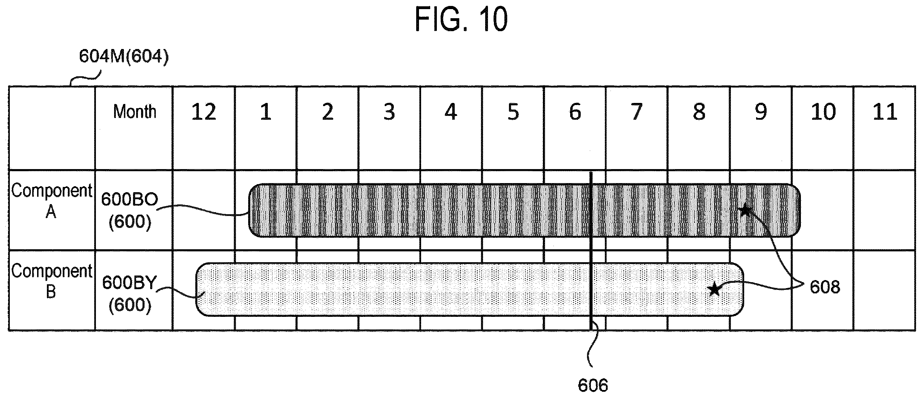

Next, differences from FIG. 9 in modifications of the display screen of the display 204 according to the embodiment are described with reference to FIGS. 10 to 12. The rest is in the same configuration as the display screen shown in FIG. 9, and substantially the same elements as those described in FIG. 9 are denoted by the same reference numerals, and description thereof is omitted.

### (Modification 1 of Display Screen)

FIG. 10 is a schematic diagram showing a modification (Modification 1) of the display screen of the display 204 according to the first embodiment. As shown in FIG. 10, the display 204 displays a service life image 600, a scale image 604, a date/time marker 606, and a prediction marker 608 as a life flag indicating an end of the predicted service life of each constituting component. The service life image 600B according to this modification includes a service life image 600BY corresponding to a case where the last detected warning level is 1, and a service life image 600BO corresponding to a case where the last detected warning level is 2. For example, the service life image 600BY is displayed in yellow, and the service life image 600BO is displayed in orange.

Herein, the prediction marker 608 is superimposed on the service life image 600 and is displayed at a position indicating the end of the predicted service life of each component. The prediction marker 608 is displayed, for example, as a star-shaped image.

In this modification, as an example, the predicted service life and warning level of the components A and B are displayed as shown in FIG. 10. Each of the displays of the rows corresponding to the components A and B are described below.

In the row corresponding to the component A, the orange service life image 600BO is displayed from a position indicating the first part of January to a position indicating the first part of October. The prediction marker 608 is displayed at a position indicating the first part of September.

In the row corresponding to the component B, the yellow service life image 600BY is displayed from a position indicating the middle part of December to a position indicating the first part of September. The prediction marker 608 is displayed at a position indicating the last part of August.

In this way, by displaying the orange service life image 600BO in the row corresponding to the component A, it is displayed that the latest warning level determined for component A is 2. In addition, by displaying the prediction marker 608 to be superimposed on the service life image 600BO in the row corresponding to the component A, it is displayed that the predicted service life of the component A is shortened by four weeks from the standard service life. That is, since there is a timing when the warning level is determined to be 2 for the component A, it is displayed that the predicted service life of the component A is shortened by four weeks. On the other hand, by displaying the yellow service life image 600BY in the row corresponding to the component B, it is displayed that the latest warning level determined for the component B is 1. In addition, by displaying the prediction marker 608 to be superimposed on the service life image 600BY of the row corresponding to the component B, it is displayed that the predicted service life of the component B is shortened by two weeks. That is, since there is a timing when the warning level is determined to be 1 for the component B, it is displayed that the predicted service life of the component B is shortened by two weeks from the standard service life. The service life image 600 may include a service life image 600 indicating that the determined latest warning level is 3. In addition to changing the color of the service life image 600, the controller 100 of the embodiment may blink the service life image 600 or display a message (for example, a message to prompt components replacement, components inventory, replacement component code, etc.).

### (Modification 2 of Display Screen)

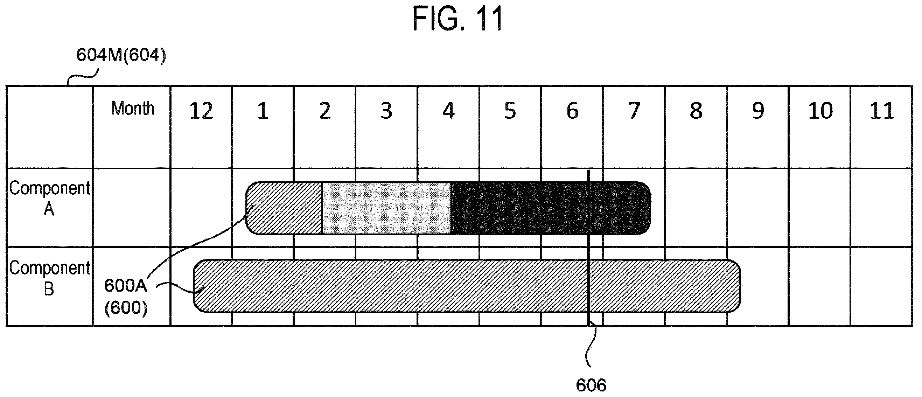

FIG. 11 is a schematic diagram showing a modification (Modification 2) of the display screen of the display 204 according to the first embodiment. As shown in Fig. 11, a service life image 600, a scale image 604, and a date/time marker 606 are displayed on the display 204. The service life image 600A according to this modification is displayed in a color that changes from a position corresponding to each warning timing to a light apricot color corresponding to warning level 1 to a red color corresponding to warning level 2.

In this modification, as an example, the predicted service life, warning timing, and warning level of the components A and B are displayed as shown in FIG. 11. The display of the row corresponding to the component A is described below. The row corresponding to the component B is the same as in FIG. 9, and therefore, description thereof is omitted.

In the row corresponding to the component A, the service life image 600A is displayed in blue from a position indicating the first part of January to a position indicating the middle part of February. In addition, the service life image 600A is displayed in light apricot color from a position indicating the middle part of February to a position indicating the middle part of April. The service life image 600A is displayed in red from a position indicating the middle part of April to a position indicating the last part of July.

In this way, by displaying the service life image 600A in the row corresponding to the component A with a change in color on the way, it is displayed that there is a timing when the warning level for the component A is determined to be 1 as the first level or 2 as the second level. It is also displayed that there is a timing when the warning level is determined to be 1 around the middle part of February when the service life image 600A is changed to light apricot color. It is also displayed that there is a timing when the warning level is determined to be 2 around the middle part of April when the service life image 600A is changed to red. After the service life image 600A is changed to light apricot color, if there is no warning timing for a predetermined period of time, the color of the service life image 600 may be returned to blue. By returning the color of the service life image 600 to blue, it is possible to display to a user that it is determined that an abnormal sound is detected by chance. In addition, the service life image 600 may be displayed in a color corresponding to the warning level being 3, starting from a position corresponding to the timing at which it is determined that the warning level is 3.

### (Modification 3 of Display Screen)

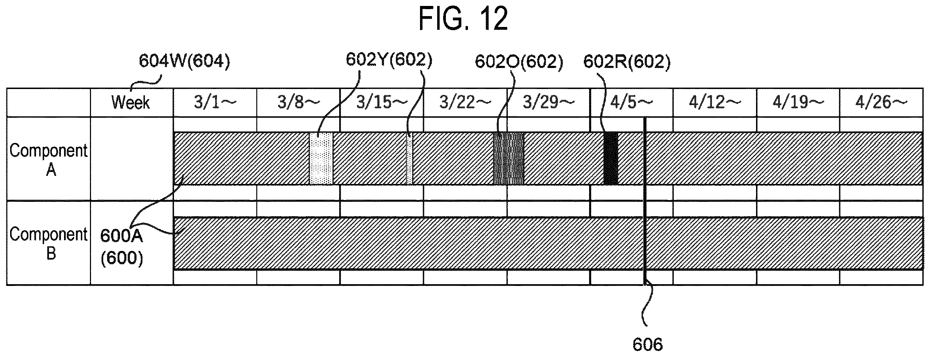

FIG. 12 is a schematic diagram showing a modification (Modification 3) of the display screen of the display 204 according to the first embodiment. As shown in FIG. 12, the display 204 displays a service life image 600, a warning image 602, a scale image 604, and a date/time marker 606.

The warning image 602 according to this modification is displayed with its width changed according to the warning level and a frequency of the warning timing. The scale image 604 is a scale image 604W showing a time scale of a week display, and a date showing the start of the week is displayed in each square at the top. The date/time marker 606 is displayed at a position indicating the current date. The warning image 602 may change a color density in addition to changing the width.

In this modification, as an example, the predicted service life, warning timing, warning level, etc. of the components A and B are displayed as shown in FIG. 12. The display of the row corresponding to the component A is described below. The row corresponding to the component B is the same as in FIG. 9, and therefore, description thereof is omitted.

In the row corresponding to the component A, the service life image 600A is displayed from a left end showing the start of the week of March 1 to a right end showing the end of the week of April 26. The warning image 602Y is displayed from a position indicating March 11 to a position indicating March 14 and at a position indicating March 20. The warning image 602O is displayed from a position indicating March 27 to a position indicating March 31. The warning image 602R is displayed from a position indicating April 6 to a position indicating April 7.

In this way, by displaying the warning images 602Y, 602O, and 602R in a way that the warning image 602 is superimposed on the service life image 600A of the row corresponding to the component A, the timing at which it is determined that the component A may be wearing out and the warning level at that timing are displayed. In addition, by changing a width of the warning image 602Y and displaying it, it is displayed that the timing at which the warning level is determined to be 1 occurs frequently during a period indicated by that width. In addition, by changing a width of the warning image 602O and displaying it, it is displayed that the timing at which the warning level is determined to be 2 occurs frequently during a period indicated by that width. In addition, by changing a width of the warning image 602R and displaying it, it is displayed that the timing at which the warning level is determined to be 3 occurs frequently during a period indicated by that width.

Further, a result of detailed analysis of an abnormal state may be displayed on the display 204. For example, when a sound is detected for the abnormal state, a scatter diagram with a vertical axis representing a volume and a horizontal axis representing a frequency may be displayed. In this case, a marker corresponding to the warning level may be plotted on the scatter diagram at the timing when the abnormality is detected. By plotting the marker at each timing when the abnormality is detected, a distribution and a density of the volume and frequency may be displayed, so that it is possible to grasp which component is abnormal, or an abnormal level of the component. For example, if a frequency of an abnormal sound is different between an elevating shaft and a rotary shaft, the frequency of the abnormal sound may be used as a reference to determine the abnormal state of each component. In addition, for example, if a new marker appears at a frequency away from a group of markers distributed in a specific frequency band, it is possible to determine an abnormal state of a component other than the component that is a target of monitoring the specific frequency band.

### (Flowchart)

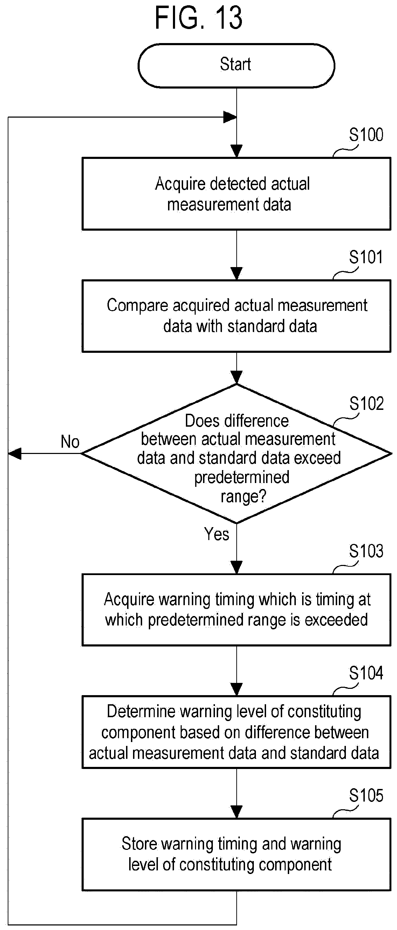

FIG. 13 is a flowchart showing an example of a flow of the storage process according to the first embodiment. This storage process is executed by the CPU 102 of the controller 100 reading a program from the storage 104 and executing it in the RAM 103 *(see* FIG. 5). As an example, the storage process shown in FIG. 13 is repeatedly executed during the operation of the substrate processing apparatus 1.

In step S100 of FIG. 13, the CPU 102 acquires detected actual measurement data. Specifically, the CPU 102 acquires the actual measurement data from the sensor actual measurement data 104D *(see* FIG. 5).

In step S101, the CPU 102 compares the acquired actual measurement data with the standard data. Specifically, the CPU 102 compares the actual measurement data acquired in step S100 with the standard data of the sensor standard data 104C *(see* FIG. 5) corresponding to this actual measurement data.

In step S102, the CPU 102 determines whether or not a difference between the actual measurement data and the standard data exceeds a predetermined range. For example, the CPU 102 determines whether or not the ratio of the difference between the peaks of the sound waveforms of the actual measurement data and the standard data is 10% or more. If the CPU 102 determines that the difference exceeds the predetermined range (step S102: YES), the process proceeds to step S103. If the CPU 102 determines that the difference does not exceed the predetermined range (step S102: NO), the process returns to step S100.

In step S103, the CPU 102 acquires the warning timing which is a timing at which the predetermined range is exceeded. Specifically, the CPU 102 acquires a timing at which the difference is determined to exceed the predetermined range in step S102.

In step S104, the CPU 102 determines the warning level of the constituting component based on the difference between the actual measurement data and the standard data. The CPU 102 determines the warning level, for example, based on the ratio of the difference between the peaks of the sound waveforms of the actual measurement data and the standard data.

In step S105, the CPU 102 stores the warning timing and the warning level of the constituting component. Specifically, the CPU 102 stores the warning timing acquired in step S103 and the warning level of the component determined in step S104 in the components data 104B (*see* FIG. 5). Then, the CPU 102 ends the storage process.

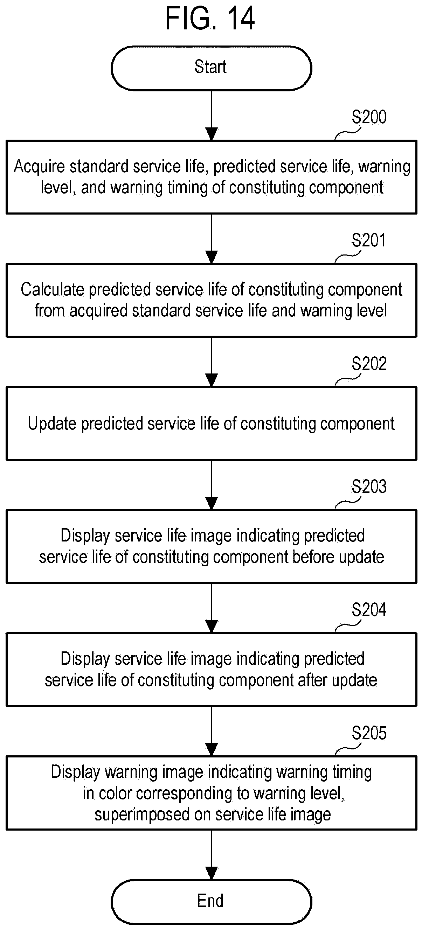

FIG. 14 is a flowchart showing an example of a flow of the display process according to the first embodiment. This display process is executed by the CPU 102 of the controller 100 reading a program from the storage 104 and executing it in the RAM 103. As an example, the display process shown in FIG. 14 is executed when a user operates the operator 212.

In step S200 of FIG. 14, the CPU 102 acquires the standard service life, predicted service life, warning level, and warning timing of the constituting component. Specifically, the CPU 102 acquires the standard service life, predicted service life, warning level, and warning timing from the components data 104B.

In step S201, the CPU 102 calculates the predicted service life of the constituting component from the acquired standard service life and warning level.

In step S202, the CPU 102 updates the predicted service life of the constituting component. Specifically, the CPU 102 updates the predicted service life stored in the components data 104B to the predicted service life calculated in step S201.

In step S203, the CPU 102 displays a service life image 600 indicating the predicted service life of the constituting component before the update. The CPU 102 displays, for example, a service life image 600B indicating the predicted service life acquired in step S200 on the display 204.

In step S204, the CPU 102 displays a service life image 600 indicating the predicted service life of the constituting component after the update. The CPU 102 displays, for example, a service life image 600A indicating the predicted service life calculated in step S201 on the display 204.

In step S205, the CPU 102 displays a warning image 602 indicating the warning timing in a color corresponding to the warning level, superimposed on the service life image 600. The CPU 102 displays, for example, warning images 602Y, 602O, and 602R corresponding to the warning level, superimposed on the service life image 600 at a position indicating the warning timing acquired in step S200, on the display 204. Then, the CPU 102 ends the display process. The images may be displayed together on the display 204.

### (Summary of First Embodiment)

According to the embodiment, one or more of the effects set forth below may be achieved.

The substrate processing apparatus 1 according to the first embodiment displays the service life image 600 indicating the predicted service life of at least an operable constituting component among the process component used in the process furnace, the flow rate control component used in the gas supplier or the gas exhauster, and the transfer control component used in the transfer mechanism, and the warning image 602 indicating that the quality state of the constituting component is determined to be at a predetermined warning level, in association with the predicted service life for each warning timing at which the warning level is determined. Therefore, according to the substrate processing apparatus 1 of the embodiment, it is possible to notify the user of the state of the component and a replacement time of the component. Further, according to the substrate processing apparatus 1 of the embodiment, by displaying the timings at which a plurality of predetermined levels are exceeded in association with the predicted service life, it is possible to continue to notify a deterioration status of the component with time taken into consideration. Furthermore, a timing at which an abnormality occurred may be inferred by a review of the replacement of the component. Then, when a plurality of warning images are displayed within a certain period of time, it is possible to increase the user's awareness of the components replacement.

In the substrate processing apparatus 1 according to the first embodiment, the warning level indicates a degree of recommendation for replacing the constituting component. Therefore, according to the substrate processing apparatus 1 of the embodiment, by displaying the quality information of the constituting component in association with the determination timing, it is possible to further increase the user's awareness of the components replacement.

In the substrate processing apparatus 1 according to the first embodiment, the transfer mechanism includes the substrate transfer mechanism 24 capable of transferring the substrate 18, and a plurality of shafts included in the transfer control component. Therefore, according to the substrate processing apparatus 1 of the embodiment, it is possible to determine an abnormality with abnormal noise of the shafts.

In the substrate processing apparatus 1 according to the first embodiment, the flow rate control component includes at least one selected from the group of the valves (the valves 52, 54, 56, and 58, the APC valve 41, etc.), the MFCs (the MFCs 51, 53, 55, 57, etc.), and the vacuum pump provided in the gas supplier or the gas exhauster. Therefore, according to the substrate processing apparatus 1 of the embodiment, it is possible to constantly detect states of the valves that may be switched at a high speed.

In the substrate processing apparatus 1 according to the first embodiment, the process furnace 28 includes the process chamber 29 in which the substrate 18 is stored, and the seal cap 34 that is adjacent to the process chamber 29, and the seal cap 34 is included in the process component. Therefore, according to the substrate processing apparatus 1 of the embodiment, it is possible to determine the quality state of the component with a sound emitted from the seal cap 34.

In the substrate processing apparatus 1 of the first embodiment, the quality state of the constituting component is determined from the actual measurement data of at least one selected from the group of the sound data, image data, temperature data, and odor data detected from the constituting component. Therefore, according to the substrate processing apparatus 1 of the embodiment, the quality state is determined based on at least one selected from the group of the operating sound, image, video, heat, and odor of the detectable components, so that the quality state may be determined with high accuracy.

The substrate processing apparatus 1 of the first embodiment is provided with the standard data to be compared with the actual measurement data, and displays the warning image 602 when the actual measurement data is compared with the standard data and the warning level is 1 or more (for example, the ratio of difference between the peaks of the sound waveforms is 10% or more). Therefore, according to the substrate processing apparatus 1 of the embodiment, the warning level may be stably determined by comparing the detected actual measurement data with the standard data.

In the substrate processing apparatus 1 of the first embodiment, the warning image 602 is displayed in different colors depending on the warning levels. For example, the status information with an extremely high warning level (i.e., the status information with an extremely high degree of recommendation for components replacement) is displayed in red. In addition, the status information with a high warning level (i.e., the status information with a high degree of recommendation for components replacement) is displayed in orange. In addition, the status information with a low warning level (i.e., the status information with a low degree of recommendation for components replacement) is displayed in yellow. Therefore, according to the substrate processing apparatus 1 of the embodiment, it is possible to present the degree of recommendation for components replacement to the user by an image indicating the warning level.

In the substrate processing apparatus 1 according to the first embodiment, the warning image 602 is in a form that indicates a plurality of warning levels according to the quality state of the constituting component, and the display of the service life image 600 is changed according to the plurality of warning levels. Therefore, according to the substrate processing apparatus 1 of the embodiment, it is possible to present the degree of recommendation for components replacement to the user by an image indicating the predicted service life of the constituting component.

In the substrate processing apparatus 1 according to the first embodiment, the service life image 600 is displayed to be superimposed on the scale image 604, and when it is determined that the warning level indicating the quality state of the constituting component is 1, the service life image 600 from the determined timing onward is displayed in light apricot color. In addition, when it is determined that the warning level indicating the quality state of the constituting component is 2, the service life image 600 from the determined timing onward is displayed in red. Therefore, according to the substrate processing apparatus 1 of the embodiment, it is possible to present the degree of recommendation for components replacement to the user by an image indicating the predicted service life of the constituting component.

In the substrate processing apparatus 1 according to the first embodiment, the service life image 600 indicates the predicted service life of the constituting component, and the substrate processing apparatus 1 calculates the predicted service life of the constituting component according to the quality state of the constituting component and displays the calculation result on the display 204. Therefore, according to the substrate processing apparatus 1 of the embodiment, the life may be recalculated each time according to the quality state and flexibly displayed, thereby prompting the user for components replacement.

In the substrate processing apparatus 1 according to the first embodiment, the service life image 600 is displayed on the display 204 with the predicted service life of the constituting component shortened according to the warning level indicating the quality state of the constituting component, or the prediction marker 608 is superimposed on the service life image 600 and displayed on the display 204. Therefore, according to the substrate processing apparatus 1 of the embodiment, it is possible to present the predicted service life of the constituting component to the user.

In the substrate processing apparatus 1 according to the first embodiment, the service life image 600A indicating the predicted service life after updating by the data updater 100D and the service life image 600B indicating the predicted service life before updating by the data updater 100D are both displayed on the display 204. Therefore, according to the substrate processing apparatus 1 of the embodiment, it is possible for the user to visually understand that the predicted service life of the constituting component is shortened.

The substrate processing apparatus 1 according to the first embodiment includes the sensor 207 that detects the actual measurement data of at least one selected from the group of the process component, flow rate control component, and transfer control component, and determines the quality state of the constituting component based on the detected actual measurement data. Therefore, according to the substrate processing apparatus 1 of the embodiment, it is possible to determine the quality state with high accuracy.

### [Second Embodiment]

The substrate processing apparatus 1 according to the first embodiment determines the warning level by comparing the quality state of the constituting component between the actual measurement data and the standard data, and displays the warning image 602 indicating the determined warning level. However, without being limited thereto, the substrate processing apparatus 1 according to the embodiment may display the warning image 602 when the number of times that the actual measurement data is determined to be at a predetermined warning level within a unit time (e.g., 24 hours) exceeds a predetermined number of times per unit time. Further, the substrate processing apparatus 1 according to the embodiment may display the warning image 602 when a difference in the actual measurement data of the constituting component is greater than a predetermined difference in the detection within the unit time.

### (Flowchart)

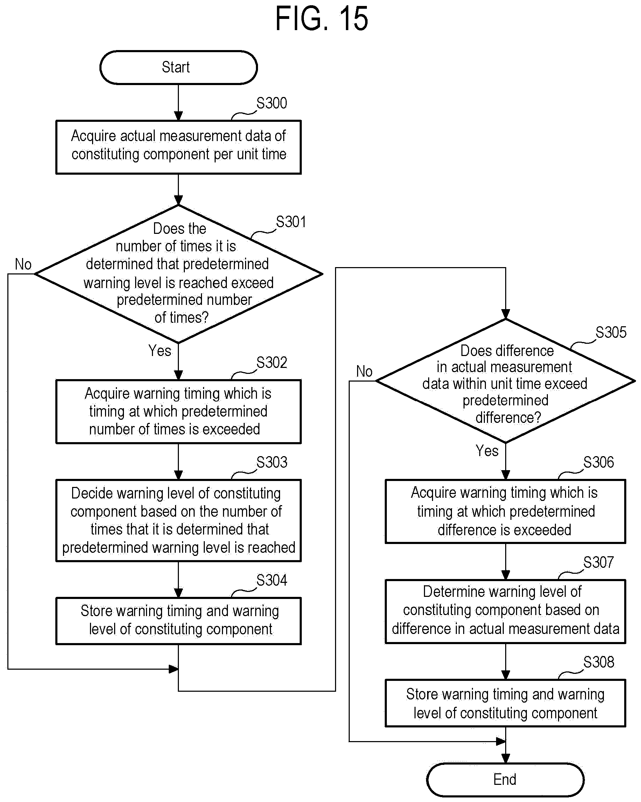

FIG. 15 is a flowchart showing an example of a flow of a storage process according to a second embodiment. As an example, the storage process shown in FIG. 15 is executed each time a set unit time elapses.

In step S300 in FIG. 15, the CPU 102 acquires the actual measurement data of the constituting component per unit time. The CPU 102 acquires the actual measurement data for the most recent 24 hours from, for example, the sensor actual measurement data 104D *(see* FIG. 5).

In step S301, the CPU 102 determines whether or not the number of times it is determined that a predetermined warning level is reached exceeds a predetermined number of times. The CPU 102 determines, for example, whether or not the number of times it is determined that the warning level is 1 exceeds five. If the CPU 102 determines that the number of times it is determined that the predetermined warning level is reached exceeds the predetermined number of times (step S301: YES), the process proceeds to step S302. On the other hand, if the CPU 102 determines that the number of times that it is determined that the predetermined warning level is reached does not exceed the predetermined number of times (step S301: NO), the process proceeds to step S305.

In step S302, the CPU 102 acquires a warning timing which is a timing at which the predetermined number of times is exceeded. For example, the CPU 102 acquires the most recent 24 hours, which is a period divided into unit times, as the warning timing.

In step S303, the CPU 102 decides the warning level of the constituting component based on the number of times that it is determined that the predetermined warning level is reached. For example, if the number of times that it is determined that the warning level is 1 is 5 or more and less than 10, the CPU 102 decides that the warning level of the constituting component is 1. In addition, if the number of times that it is determined that the warning level is 1 is 10 or more, the CPU 102 decides that the warning level of the constituting component is 2.

In step S304, the CPU 102 stores the warning timing and the warning level of the constituting component. Specifically, the CPU 102 stores the warning timing acquired in step S302 and the warning level of the constituting component decided in step S303 in the components data 104B.

In step S305, the CPU 102 determines whether or not a difference in the actual measurement data within a unit time exceeds a predetermined difference. For example, the CPU 102 determines whether or not another peak in a waveform of sound data for the most recent 24 hours shows a difference of 10% or more as a predetermined difference with respect to a certain peak as a reference. If the CPU 102 determines that the difference in the actual measurement data within the unit time exceeds the predetermined difference (step S305: YES), the process proceeds to step S306. On the other hand, if the CPU 102 determines that the difference in the actual measurement data within the unit time does not exceed the predetermined difference (step S305: NO), the storage process ends.

In step S306, the CPU 102 acquires a warning timing which is a timing at which the predetermined difference is exceeded. For example, the CPU 102 acquires a timing of the another peak in the waveform of the sound data as the warning timing. A period divided into unit times (for example, the most recent 24 hours) may be acquired as the warning timing.

In step S307, the CPU 102 determines the warning level of the constituting component based on the difference in the actual measurement data. For example, when a difference in the peaks in the waveform of the sound data within the unit time is 10% or more and less than 30%, the CPU 102 determines that the warning level is 1.

In step S308, the CPU 102 stores the warning timing and the warning level of the constituting component. Specifically, the CPU 102 stores the warning timing acquired in step S306 and the warning level of the constituting component determined in step S307 in the components data 104B. Then, the CPU 102 ends the storage process.

### (Summary of Second Embodiment)

The second embodiment also obtains the same effects as the above-described embodiment. Further, according to the second embodiment, one or more of the effects set forth below may be achieved.

The substrate processing apparatus 1 according to the second embodiment judges the warning level when a predetermined condition related to the quality state of the constituting component is satisfied during the detection within a unit time while the component is operating, and displays the warning image 602 on the display 204. Therefore, according to the substrate processing apparatus 1 of the embodiment, it is possible to determine the quality state of the component comprehensively from the detection data within the unit time.

In the substrate processing apparatus 1 according to the second embodiment, the warning image 602 is displayed when the number of times that the warning level indicating the quality state of the constituting component is determined to be 1 or more in the detection within the unit time exceeds a predetermined number. Therefore, according to the substrate processing apparatus 1 of the embodiment, when the warning level indicating the quality state of the constituting component is frequently determined to be 1 or more, it is possible to prompt the user to replace the constituting component.

In the substrate processing apparatus 1 according to the second embodiment, the warning image 602 is displayed when a difference in the actual measurement data of the constituting component exceeds a predetermined difference during detection within a unit time. Therefore, according to the substrate processing apparatus 1 of the embodiment, it is possible to determine the quality state of the constituting component solely from the actual measurement data of the component and prompt the user to replace the constituting component.

### [Other Embodiments]

The substrate processing apparatus 1 of the first embodiment displays the service life image 600 and the warning image 602 on the display 204. However, the first embodiment is not limited thereto, and the management apparatus 70 of the embodiment may display the service life image 600 and the warning image 602 on the display 84 of the management apparatus 70. The same effects as the above-described embodiments may be obtained in other embodiments.

The management apparatus 70 according to the embodiment receives the actual measurement data detected by the sensor 207 of the substrate processing apparatus 1 via the external communicator 81 as a receiver, and displays the service life image 600 and the warning image 602 on the display 84 by the device controller 71 as a control part. Therefore, according to the management apparatus 70 of the embodiment, it is possible to notify a user at a remote location of the substrate processing apparatus 1 of the state of the constituting component and the timing of replacing the constituting component.

The management apparatus 70 may acquire information such as the type of process used by each substrate processing apparatus 1, the usage time, the number of times of use, etc., or constituting component replacement information, etc., and display maintenance information for prompting replacement of each constituting component on the display 204 of each substrate processing apparatus 1. According to the management apparatus 70 of the embodiment, it is possible to collect information on the same type of components and co-located components from a plurality of substrate processing apparatuses 1, and compare the components data in the management apparatus. That is, according to the management apparatus 70 of the embodiment, it is possible to easily grasp the quality state of components of a specific substrate processing apparatus 1 by comparing it with a substrate processing apparatus 1 that is operating normally.

The above-described embodiments and modifications may be used in appropriate combination. The process procedures and process conditions at this time may be the same as those of the above-described embodiments and modifications. Further, the configurations of the processing system 90, management apparatus 70, and substrate processing apparatus 1 described in the above-described embodiments and modifications are merely examples, and may be modified according to circumstances without departing from the spirit of the present disclosure.

Further, the flow of processing the program described in the above-described embodiments is also merely an example, and steps that are not needed may be deleted, new steps may be added, or the processing order may be rearranged, without departing from the spirit of the present disclosure.

In addition, in the above-described embodiments, a case is described in which the processing according to the embodiments is realized by a software configuration using a computer by executing a program, but the embodiments are not limited thereto. The embodiments may be realized, for example, by a hardware configuration or a combination of a hardware configuration and a software configuration.

In the above-described embodiments, the term CPU refers to a processor in a broad sense, and includes a general processor such as a CPU (Central Processing Unit) and dedicated processors such as a GPU (Graphics Processing Unit), an ASIC (Application Specific Integrated Circuit), a FPGA (Field Programmable Gate Array), and a programmable logic device.

Further, the operation of the processor in the above-described embodiments may be performed by a single processor or by a plurality of processors working in cooperation, which are located in physically separate locations. Furthermore, the order of each operation of the processor is not limited to the order described in the above-described embodiments, and may be changed as appropriate.

In the above-described embodiments, an example of forming a film by using a batch-type substrate processing apparatus that processes a plurality of substrates at a time is described. The present disclosure is not limited to the above-described embodiments, and may also be suitably applied, for example, to a case of forming a film by using a single-wafer type substrate processing apparatus that processes one or several substrates at a time. Further, in the above-described embodiments, an example of forming a film by using a substrate processing apparatus with a hot-wall type process furnace is described. The present disclosure is not limited to the above-described embodiments, and may also be suitably applied to a case of forming a film by using a substrate processing apparatus with a cold-wall type process furnace.

Even when using these substrate processing apparatuses, each process may be performed using the same process procedures and process conditions as in the above-described embodiments, and the same effects as in the above-described embodiments may be obtained.

According to the present disclosure in some embodiments, it is possible to notify a user of a condition of component and a replacement time of the component in a substrate processing apparatus.

While certain embodiments are described, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A display method, comprising:
displaying time information indicating a usage time of a component including an operable component among a process component used in a processor that processes a substrate, a flow rate control component used in an atmosphere controller that includes a gas supply system or a gas exhaust system and is configured to be capable of controlling an internal atmosphere of the processor, and a transfer control component used in a transferer that transfers the substrate, and quality information indicating that the component is determined to be in a predetermined level of a quality state, in association with the time information for each determination timing of the quality state.

2. The display method of Claim 1, wherein the predetermined level indicates a level that prompts replacement of the component.

3. The display method of Claim 1, wherein the transferer includes a transfer robot that is configured to be capable of transferring the substrate and a driver that drives the transfer robot, and
wherein the transfer control component is the driver.

4. The display method of Claim 1, wherein the flow rate control component is at least one selected from the group of a valve, a mass flow controller, and a pump included in the gas supply system or the gas exhaust system.

5. The display method of Claim 1, wherein the processor includes a process chamber in which the substrate is stored, and a sealing portion adjacent to the process chamber, and
wherein the process component is the sealing portion.

6. The display method of Claim 1, wherein the quality state is determined from status information indicating at least one selected from the group of an operating sound, an image, a video, a temperature, and an odor of the component.

7. The display method of Claim 1, wherein, while the component is in operation, when a predetermined condition regarding the quality state of the component is satisfied in detection within a unit time, the quality state is determined to be at a predetermined level, and the quality information is additionally displayed on a display.

8. The display method of Claim 1, wherein the quality information is displayed in different colors depending on a state of the component.

9. The display method of Claim 1, wherein the quality information includes a plurality of levels according to the quality state of the component, and the time information is displayed to be different depending on a level of the quality information.

10. The display method of Claim 1, wherein the time information is an expected usage period of the component, and
wherein the expected usage period of the component is calculated according to the quality state of the component, and a calculation result is reflected on a display.

11. The display method of Claim 1, wherein status information indicating a status of at least one selected from the group of the process component, the flow rate control component, and the transfer control component is detected, and
wherein the quality information of the component is determined based on the status information.

12. A method of manufacturing a semiconductor device comprising the display method of Claim1, further comprising:
transferring the substrate to the processor; and
processing the substrate.

13. A program that causes, by a computer, a substrate processing apparatus to perform a process comprising:
displaying time information indicating a usage time of a component including an operable component among a process component used in a processor that processes a substrate, a flow rate control component used in an atmosphere controller that includes a gas supply system or a gas exhaust system and is configured to be capable of controlling an internal atmosphere of the processor, and a transfer control component used in a transferer that transfers the substrate, and quality information indicating that the component is determined to be in a predetermined level of a quality state, in association with the time information for each determination timing of the quality state.

14. A processing apparatus comprising:
a controller (100) that is configured to be capable of displaying, on a display, time information indicating a usage time of a component including an operable component among a process component used in a processor that processes a substrate, a flow rate control component used in an atmosphere controller that includes a gas supply system or a gas exhaust system and is configured to be capable of controlling an internal atmosphere of the processor, and a transfer control component used in a transferer that transfers the substrate, and quality information indicating that the component is determined to be in a predetermined level of a quality state, in association with the time information for each determination timing of the quality state.

15. A management apparatus comprising:
a receiver that receives status information detected by a detector included in a substrate processing apparatus; and
a controller (100) that causes a display to display time information indicating a usage time of a component including an operable component among a processing component used in a processor that processes a substrate, a flow rate control component used in an atmosphere controller that includes a gas supply system or a gas exhaust system and is configured to be capable of controlling an internal atmosphere of the processor, and a transfer control component used in a transferer that transfers the substrate, and quality information indicating that the component is determined to be in a predetermined level of a quality state based on the status information, in association with the time information for each determination timing of the quality state,
wherein the substrate processing apparatus includes:
the processor that processes the substrate;
the atmosphere controller configured to be capable of controlling a supply of a gas or an exhaust of a gas to or from the processor;
the transferer that transfers the substrate; and
the detector that detects the status information indicating a status of at least one selected from the group of the processing component used in the processor, the flow rate control component used in the atmosphere controller, and the transfer control component used in the transferer.
